# EUROPEAN PATENT APPLICATION

(11) **EP 3 967 787 A1**
(43) Date of publication of application: **16.03.2022**
(21) Application number: 20883530.6
(22) Date of filing: 24.07.2020
(51) Int. Cl.: C23C 14/04, C23C 14/24

(54) **MASK PLATE**

(30) Priority: 31.10.2019 CN 201911053494
(71) Applicant: KUNSHAN GO-VISIONOX OPTO-ELECTRONICS CO., LTD., Kunshan, Jiangsu 215300 (CN)
(72) Inventor: ZHANG, Zhiyuan, Kunshan, Jiangsu 215300 (CN)
(74) Representative: Sticht, Andreas
(86) International application number: PCT/CN2020/104350
(87) International publication number: WO 2021/082549

(57) **Abstract**

Provided is a mask. The mask includes a frame and an opening surrounded by the frame, a shielding portion, and at least one connection portion each connecting the shielding portion and the frame. The shielding portion is disposed in the opening. Along a direction perpendicular to the mask, the connection portion includes a first part arranged close to a substrate to be evaporated and a second part arranged away from the substrate to be evaporated. A vertical projection of the second part covers a vertical projection of the first part. An area of a cross-section of the first part parallel to the mask gradually decreases along a direction away from the second part.

## Description

This application claims priority to Chinese Patent Application No. 201911053494.9 filed with the CNIPA on October 31, 2019, the disclosures of which are incorporated herein by reference in their entirety.

### TECHNICAL FIELD

Embodiments of the present application relate to mask technologies, for example, a mask.

### BACKGROUND

With the advancement of display technologies and the improvement of living standards, the role of display panels has become larger and larger, and there are more and more types of display panels. The display area of the display panel has different display effects. For example, screens such as a perforated screen have become the new direction.

However, in the perforated screen, the overall display panel is more likely to be damaged, resulting in poor overall display effect of the display panel.

### SUMMARY

The present application provides a mask so that display panels with different display effects in the display area can be simply and efficiently prepared.

Embodiments of the present application provide a mask. The mask includes a frame and an opening surrounded by the frame, a shielding portion, and at least one connection portion each connecting the shielding portion and the frame. The shielding portion is disposed in the opening. Along a direction perpendicular to the mask, the connection portion includes a first part arranged close to a substrate to be evaporated and a second part arranged away from the substrate to be evaporated. A vertical projection of the second part covers a vertical projection of the first part. An area of a cross-section of the first part parallel to the mask gradually decreases along a direction away from the second part.

The mask used in the present disclosure includes a frame and an opening surrounded by the frame, a shielding portion, and at least one connection portion each connecting the shielding portion and the frame. The shielding portion is disposed in the opening. Along a direction perpendicular to the mask, the connection portion includes a first part close to a substrate to be evaporated and a second part away from the substrate to be evaporated. A vertical projection of the second part covers a vertical projection of the first part. An area of a cross-section of the first part parallel to the mask gradually decreases along a direction close to the substrate to be evaporated. In the case where a film layer of a display panel is evaporated by using the mask, the shielding portion of an offshore design may be effectively and stably supported by using the connection portion, and the position corresponding to the connection portion on the display panel may be formed with a corresponding film layer structure through oblique evaporation. In this manner, the following problem can be avoided: the position corresponding to the connection portion on the display panel is not evaporated with the material so that the display effect of the display panel is affected. This configuration is conducive to simply and efficiently preparing display panels with different display effects in the display area.

### BRIEF DESCRIPTION OF DRAWINGS

FIG 1 is a structure diagram of a mask according to an embodiment of the present application;
FIG 2 is a sectional diagram of FIG. 1 taken along an A1-A2 direction;
FIG. 3 is a schematic diagram of an evaporation process according to an embodiment of the present application;
FIG. 4 is another sectional diagram of FIG. 1 taken along the A1-A2 direction, where a connection portion has a different cross-sectional shape from a connection portion in FIG. 2;
FIG. 5 is a schematic diagram of another evaporation process according to an embodiment of the present application;
FIG. 6 is another sectional diagram of FIG. 1 taken along the A1-A2 direction, where a connection portion has a different cross-sectional shape from the connection portion in FIG. 2;
FIG. 7 is a sectional diagram of FIG. 1 taken along an A3-A4 direction;
FIG. 8 is another sectional diagram of FIG. 1 taken along the A1-A2 direction, where a connection portion has a different cross-sectional shape from the connection portion in FIG. 2;
FIG. 9 is another sectional diagram of FIG. 1 taken along the A1-A2 direction, where a connection portion has a different cross-sectional shape from the connection portion in FIG. 2;
FIG. 10 is a sectional diagram of FIG. 1 taken along an A5-A6 direction;
FIG. 11 is a structure diagram of another mask according to an embodiment of the present application, where one shielding portion corresponds to three connection portions, extension directions of two connection portions of the three connection portions are perpendicular to each other, and an extension direction of another connection portion is between the two connection portions that are perpendicular to each other;
FIG. 12 is a structure diagram of another mask according to an embodiment of the present application, where one shielding portion corresponds to four connection portions, extension directions of two connection portions of the four connection portions are parallel to a first direction, extension directions of the other two connection portions are parallel to a second direction, and the first direction is perpendicular to the second direction; and
FIG. 13 is a structure diagram of another mask according to an embodiment of the present application, where one shielding portion corresponds to three connection portions, extension directions of two connection portions of the three connection portions are the same and are located on the same straight line, and an extension direction of another connection portion is perpendicular to the straight line.

### DETAILED DESCRIPTION

The present application is described hereinafter in conjunction with drawings and embodiments. The embodiments described herein are intended to explain and not to limit the present application. In addition, for ease of description, only part, not all, of structures related to the present application are illustrated in the drawings.

Just as mentioned in the background, the perforated screen has the problem that the overall display panel is easily damaged. After a careful study, it is found that the reason for this technical problem is: in the related art, in the case where a perforated screen is made, a whole layer of film layer structure is made by using a mask first, and then a hole-like structure is formed on the film layer structure by laser drilling. However, the laser drilling technology is relatively difficult, and thus it is relatively easy to damage the film layer structure of the display panel.

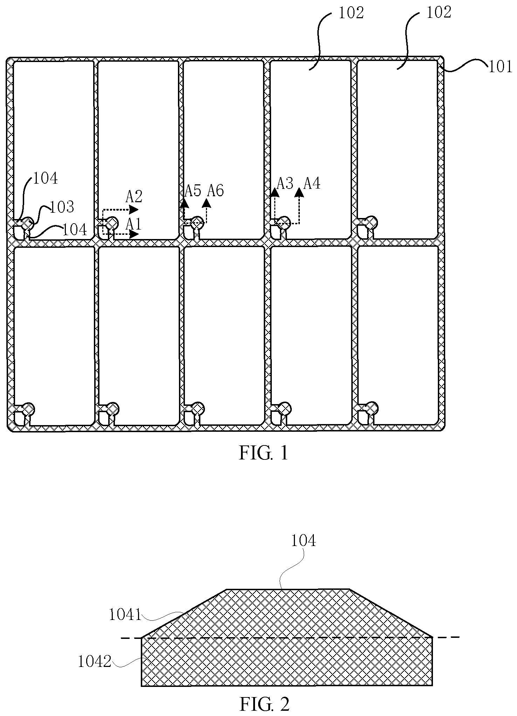

FIG. 1 is a structure diagram of a mask according to an embodiment of the present application, and FIG. 2 is a sectional diagram of FIG. 1 taken along an A1-A2 direction. Referring to FIGS. 1 and 2, the mask includes a frame 101 and an opening 102 surrounded by the frame 101, a shielding portion 103, and at least one connection portion 104 each connecting the shielding portion 103 and the frame 101. The shielding portion 103 is disposed in the opening 102. Along a direction perpendicular to the mask, the connection portion 104 includes a first part 1041 arranged close to a substrate to be evaporated and a second part 1042 arranged away from the substrate to be evaporated. A vertical projection of the second part 1042 covers a vertical projection of the first part 1041. An area of a cross-section of the first part 1041 parallel to the mask gradually decreases along a direction away from the second part 1042.

In an embodiment, in conjunction with FIGS. 1 and 2, the mask may be used for making a display panel. One mask includes multiple openings 102, each opening 102 corresponds to one display panel, and the shielding portion 103 in the opening 102 is configured to avoid the evaporation of a corresponding material to an area of the display panel that does not need to be formed with a corresponding film layer of the material when the film layer (such as a cathode layer or an encapsulation layer) of the display panel is evaporated. For example, the area may be a designated area (such as a perforated area) that is different from other display areas. In this manner, the following problem can be avoided: a whole film layer is made first, and then laser drilling is performed so that the film layer is damaged, and thus the display quality of the display panel is affected.

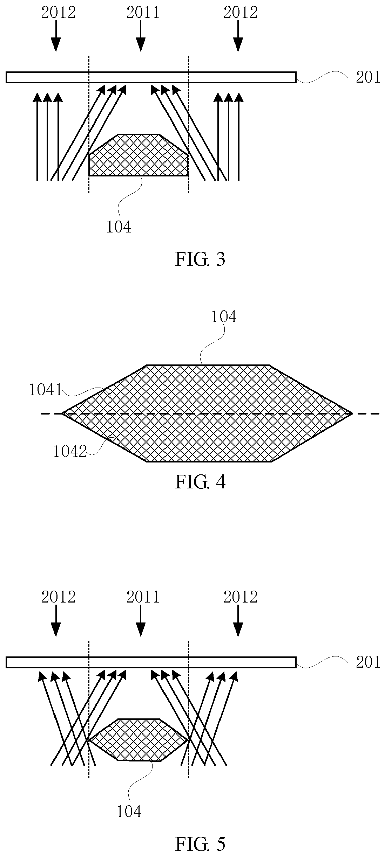

In this embodiment, the area of the cross-section of the first part 1041 parallel to the mask gradually decreases along the direction away from the second part 1042, which may mean that the width of the cross-section of the first part 1041 gradually decreases. FIG. 2 exemplarily shows that the left and right sides of the connection portion 104 have a symmetrical structure. In an embodiment, the connection portion 104 may also be provided as a non-symmetrical structure. FIG. 3 is a schematic diagram of an evaporation process according to an embodiment of the present application. In conjunction with FIGS. 2 and 3, in the case where the film layer of the display panel is evaporated by using the mask, the substrate 201 to be evaporated is disposed above the mask, the first part 1041 of the connection portion 104 is close to the substrate 201 to be evaporated, the second part 1042 of the connection portion 104 is away from the substrate 201 to be evaporated, and the substrate 201 to be evaporated includes a shielded area 2011 that is shielded by the connection portion 104 and an unshielded area 2012 that is not shielded by the connection portion 104. For example, in the case a cathode layer in the display panel is evaporated by using the mask provided in embodiments of the present application, only the perforated area, which is the area on the substrate to be evaporated corresponding to the shielding portion 103, needs to be shielded by the shielding portion 103 so that the area is prevented from being formed with the cathode material, and the remaining area needs to be formed with the cathode material. That is, both the shielded area 2011 and the unshielded area 2012 need to be evaporated with corresponding film layer structures, and the material is evaporated from bottom to top on the substrate to be evaporated 201 during evaporation so that the unshielded area 2012 is evaporated with a film layer structure in the vertical direction. Moreover, since the area of the cross-section of the first part 1041 parallel to the mask gradually decreases along the direction close to the substrate to be evaporated 201, the shielded area 2011 is evaporated with a film layer structure through oblique evaporation. In this manner, the following problem can be avoided: the position corresponding to the connection portion 104 on the display panel is not evaporated with the material so that the display effect of the display panel is affected.

The boundary between the first part 1041 and the second part 1042 of the connection portion 104 along the direction perpendicular to the mask is not limited in embodiments of the present application as long as it is ensured that the area of the cross-section of the first part 1041 parallel to the mask gradually decreases along the direction away from the second part 1042.

The mask used in this embodiment includes a frame and an opening surrounded by the frame, a shielding portion, and at least one connection portion each connecting the shielding portion and the frame. The shielding portion is disposed in the opening. Along a direction perpendicular to the mask, the connection portion includes a first part arranged close to a substrate to be evaporated and a second part arranged away from the substrate to be evaporated. A vertical projection of the second part covers a vertical projection of the first part. An area of a cross-section of the first part parallel to the mask gradually decreases along a direction away from the second part. In the case where the film layer of the display panel is evaporated by using the mask, the connection portion effectively and stably supports the shielding portion, the area on the display panel corresponding to the shielding portion cannot be evaporated with a film layer structure, and the position on the display panel corresponding to the connection portion is formed with a corresponding film layer structure through oblique evaporation. In this manner, the following problem can be avoided: the position corresponding to the connection portion on the display panel is not evaporated with the material so that the display effect of the display panel is affected. This configuration is conducive to simply and efficiently preparing display panels with different display effects in the display area.

In an embodiment, FIG. 4 is another sectional diagram of FIG. 1 taken along the A1-A2 direction. Referring to FIG. 4, along the direction perpendicular to the mask, an area of a cross-section of the second part 1042 parallel to the mask gradually decreases along a direction away from the first part 1041.

In an embodiment, FIG. 5 is a schematic diagram of another evaporation process according to an embodiment of the present application. In conjunction with FIGS. 4 and 5, both the shielded area 2011 and the unshielded area 2012 need to be evaporated with film layer structures, and the evaporation material is evaporated from bottom to top on the substrate to be evaporated 201 during evaporation; the area on the unshielded area 2012 away from the shielded area 2011 may not only be evaporated with a film layer structure in the vertical direction, but also be evaporated with part of a film layer structure through oblique evaporation. Since the area close to the shielded area 2011 is shielded by the connection portion 104, the area may only be evaporated with a film layer structure in the vertical direction, that is, the thickness of the film layer of an area of the unshielded area 2012 close to the shielded area 2011 may be less than the thickness of the film layer of an area of the unshielded area 2012 away from the shielded area 2011 so that the thickness of the film layer of the display panel is uneven, and thus the display effect is affected. The area of the cross-section of the second part 1042 parallel to the mask gradually decreases along the direction away from the first part 1041 so that the evaporation material, evaporated from the area corresponding to the connection portion 104 to the area of the unshielded area 2012 close to the shielded area 2011 in an oblique manner, is relatively less shielded by the second part 1042, and thus the area of the unshielded area 2012 close to the shielded area 2011 is evaporated with a certain film layer structure in an oblique manner. With this configuration, the difference between the thickness of the film layer structure of the area of the unshielded area 2012 close to the shielded area 2011 and the thickness of the film layer structure of the area of the unshielded area 2012 away from the shielded area 2011 is reduced. In this manner, the uniformity of the thickness of the film layer on the display panel is improved, and the display uniformity is improved so that the display effect is further improved.

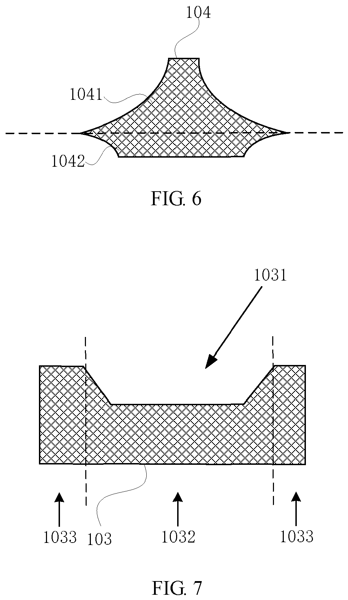

In an embodiment, the sectional diagrams shown in FIGS. 2 and 4 are only examples, and in other embodiments, other shapes may also be used. Optionally, the area of the cross-section of the first part 1041 parallel to the mask may decrease non-linearly along the direction away from the second part 1042, and the area of the cross-section of the second part parallel to the mask may decrease non-linearly along the direction away from the first part 1041. Exemplarily, FIG. 6 is another sectional diagram of FIG. 1 taken along the A1-A2 direction. As shown in FIG. 6, both the side of the first part 1041 and the side of the second part 1042 may be arc-shaped structures so that the production difficulty of the connection portion is reduced and the production costs are reduced.

In an embodiment, FIG. 7 is a sectional diagram of FIG. 1 taken along an A3-A4 direction. In conjunction with FIGS. 1 and 7, a surface of the shielding portion 103 close to the substrate to be evaporated is provided with at least one first groove, and/or a surface of the shielding portion 103 away from the substrate to be evaporated is provided with at least one first groove. Exemplarily, in FIG. 7, the surface of the shielding portion 103 close to the substrate to be evaporated is provided with one first groove 1031, that is, an upper surface of the shielding portion 103 is provided with one first groove 1031. Embodiments of the present application do not limit the number of first grooves 1031 provided on one surface of the shielding portion 103 and the number of surfaces, which is provided with the first groove 1031, of the shielding portion 103.

In an embodiment, the shielding portion 103 corresponds to the area that needs to be perforated on the display panel. The area that needs to be perforated on the display panel does not need to be evaporated to form a corresponding film layer structure (such as a cathode layer and a thin film encapsulation layer). If the weight of the shielding portion 103 is too great, the gravity of the shielding portion 103 causes the shielding portion 103 to be easily deformed so that part of the area on the display panel corresponding to the shielding portion 103 may be evaporated with a film layer structure, the film layer structure of the area on the display panel corresponding to the shielding portion 103 is affected, and thus the yield of the display panel is reduced. Moreover, excessive weight of the shielding portion 103 may easily cause deformation of the connection portion 104 supporting the shielding portion 103 so that the evaporation effect of the area on the display panel corresponding to the connection portion 104 is affected. In embodiments of the present application, the surface of the shielding portion 103 close to the substrate to be evaporated is provided with at least one first groove, and/or the surface of the shielding portion 103 away from the substrate to be evaporated is provided with at least one first groove. In this manner, the weight of the shielding portion 103 is reduced, the probability of deformation of the shielding portion 103 and the connection portion 104 is reduced, the evaporation effect of the area on the display panel corresponding to the shielding portion 103 and the connection portion 104 is improved, and thus the display effect of the display panel is improved.

In an embodiment, with continued reference to FIG. 7, the shielding portion 103 includes a middle area 1032 and an edge area 1033 surrounding the middle area 1032, and the first groove 1031 is located in the middle area 1032. In an embodiment, the shape of the shielding portion 103 may be circular, and the edge area 1033 may be annular. If the thickness of the edge area 1033 is too small, too much evaporation material reaches the position on the display panel corresponding to the shielding portion in an oblique manner during evaporation. In this manner, the area arranged on the display panel corresponding to the shielding portion 103 that does not need to be formed with a corresponding film layer is formed with the corresponding film material, and thus the yield of the display panel is reduced. In embodiments of the present application, the first groove 1031 is disposed in the middle area 1032 so that the thickness of the edge area 1033 is greater than the thickness of the middle area 1032, and the thickness of the edge area 1033 is not too small. In this manner, the probability of the evaporation material being evaporated on the area corresponding to the shielding portion on the display panel in an oblique manner during evaporation is reduced, and thus the yield of the display panel is further improved.

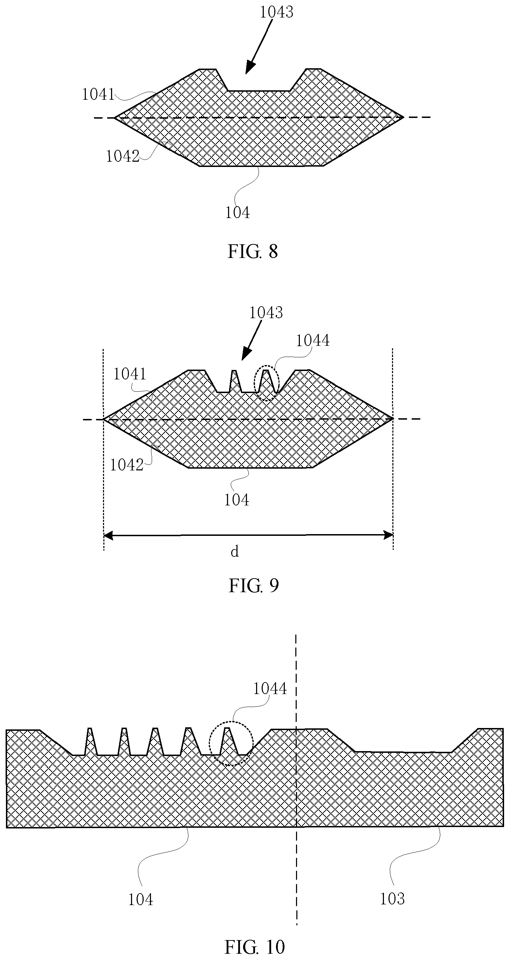

In an embodiment, FIG. 8 is another sectional diagram of FIG. 1 taken along the A1-A2 direction. Referring to FIG. 8, a surface of the connection portion 104 close to the substrate to be evaporated is provided with at least one second groove, and/or a surface of the connection portion 104 away from the substrate to be evaporated is provided with at least one second groove. Exemplarily, in FIG. 8, the surface of the connection portion 104 close to the substrate to be evaporated is provided with one second groove 1043, that is, an upper surface of the connection portion 104 is provided with one second groove 1043. Embodiments of the present application do not limit the number of second grooves 1043 provided on one surface of the connection portion 104 and the number of surfaces, which is provided with the second groove 1043, of the connection portion 104.

In an embodiment, if the weight of the connection portion 104 is too great, the gravity of the connection portion 104 causes the connection portion 104 to be easily deformed so that the film layer structure of the area on the display panel corresponding to the connection portion 104 is affected, and thus the yield of the display panel is reduced. Moreover, the connection portion 104 plays a role of fixing and supporting the shielding portion 103. The deformation of the connection portion 104 reduces the ability of the connection portion 104 to support the shielding portion 103, and the deformation of the connection portion 104 may cause the position of the shielding portion 103 to change so that the evaporation effect of the area on the display panel corresponding to the shielding portion 103 is affected. In embodiments of the present application, the surface of the connection portion 104 close to the substrate to be evaporated is provided with at least one second groove, and/or the surface of the connection portion 104 away from the substrate to be evaporated is provided with at least one second groove. In this manner, the weight of the connection portion 104 is reduced; the probability of deformation of the connection portion 104 is reduced; the following phenomenon is avoided: due to the excessive weight of the connection portion 104, the connection portion 104 sags so that the shielding portion 103 sags too much. It is further ensured that the area on the display panel corresponding to the shielding portion 103 is not evaporated with a film layer structure; the evaporation effect of the area corresponding to the shielding portion 103 and the connection portion 104 on the display panel is improved; and thus the display effect of the display panel is improved.

In an embodiment, FIG. 9 is another sectional diagram of FIG. 1 taken along the A1-A2 direction. Referring to FIG. 9, the surface of the connection portion 104 close to the substrate to be evaporated is provided with at least one second groove 1043, multiple protruding structures 1044 are provided in the second groove 1043.

In an embodiment, in the case where the display panel is evaporated, a magnetic material needs to be disposed on one side of the substrate to be evaporated away from the mask to attract the mask to prevent the mask from sagging. However, the magnetic material may make the mask attracted to the substrate to be evaporated. In this manner, no gap between the connection portion 104 and the substrate to be evaporated exists, and the evaporation material cannot be evaporated on the position on the display panel corresponding to the connection portion 104 during evaporation so that the thickness of the film layer is uneven, and thus the display effect is affected. Multiple protruding structures 1044 are provided. In the case where the connection portion 104 is attached to the surface of the substrate to be evaporated due to being attracted, the protruding structures 1044 may support the connection portion 104 so that the connection portion 104 may be prevented from being completely attached to the substrate to be evaporated. The areas of the display panel corresponding to gaps of the multiple protruding structures 1044 may be evaporated with film layer structures so that the following phenomenon is avoided: the area on the display panel corresponding to the connection portion 104 cannot be evaporated with the film layer structure so that the display is uneven; and thus the display effect is improved.

In an embodiment, as shown in FIG. 9, multiple protruding structures 1044 may be arranged along a direction perpendicular to an extension direction of the connection portion 103. Alternatively, as shown in FIG. 10, FIG. 10 is a sectional diagram of FIG. 1 taken along an A5-A6 direction. FIG. 10 shows a diagram in which multiple protruding structures 1044 are arranged along the extension direction of the connection portion 103. In an embodiment, multiple protruding structures 1044 may be arranged along the extension direction of the connection portion 103. Alternatively, multiple protruding structures 1044 may be arranged both along the direction perpendicular to the extension direction of the connection portion 103 and along the extension direction of the connection portion 103. For example, part of the multiple protruding structures 1044 are arranged along the direction perpendicular to the extension direction of the connection portion 103, and the remaining protruding structures 1044 are arranged along the extension direction of the connection portion 103. Exemplarily, multiple protruding structures 1044 may be arranged in a lattice, that is, each protruding structure 1044 is an isolated island-like structure. For example, in FIG. 10, the protruding structure 1044 may be set as a trapezoidal mesa-like structure, that is, the shapes of the upper surface and the lower surface of the protruding structure 1044 are both circular, and the side of the protruding structure 1044 close to the substrate to be evaporated may be parallel to the substrate to be evaporated. In the case where the connection portion 104 is attached to the surface of the substrate to be evaporated, the protruding structure 1044 may support the connection portion 104 so that the connection portion 104 is prevented from being completely attached to the surface of the substrate to be evaporated. In an embodiment, exemplarily, in FIG. 10, the cross-section of the protruding structure 1044 is set as a regular trapezoid, or the cross-section of the protruding structure 1044 may also be set as a rectangle or an inverted trapezoid. Embodiments of the present application do not limit the shape of the cross-section of the protruding structure 1044 as long as it is ensured that the side of the protruding structure 1044 facing the substrate to be evaporated has a supporting platform.

In an embodiment, with continued reference to FIGS. 9 and 10, along the direction perpendicular to the mask, the heights of multiple protruding structures 1044 are the same; and/or multiple protruding structures 1044 are evenly distributed.

In an embodiment, heights of multiple protruding structures 1044 are the same. In this manner, in the case where the mask is attached to the substrate to be evaporated, the multiple protruding structures 1044 support the mask, and the supporting heights are the same so that it is ensured that the extension direction of the connection portion 104 is parallel to the substrate to be evaporated, and then it is ensured that the shielding portion 103 is also parallel to the substrate to be evaporated, and thus the following case is avoided: the shielding portion 103 tilts so that the area on the display panel corresponding to the shielding portion 103 is evaporated with a film layer structure. At the same time, multiple protruding structures 1044 may be evenly distributed, and the multiple protruding structures 1044 are evenly arranged in the second groove. In this manner, the weight distribution of the connection portion 104 is more uniform; the following phenomenon is avoided: part of the weight of the connection portion 104 is too great so that the amount of sagging of this part is too great, and thus the shielding portion 103 tilts; and thus the following case is further avoided: the area on the display panel corresponding to the shielding portion 103 is evaporated with a film layer structure.

In an embodiment, as shown in FIG. 1, the connection portion 104 may be arranged to be linear. The connection portion 104 is set as a linear structure. In this manner, while the linear connection portion 104 is used for providing support for the shielding portion 103, the structure of the mask is relatively simple, which is conducive to reducing the difficulty of the manufacturing process of the mask. Moreover, the connection portion 104 is arranged to be linear, and the connection portion of the shortest structure is used for achieving the connection between the shielding portion 103 and the mask frame 101, which is conducive to reducing the weight of the connection portion 104 and the area of the connection portion 104. Therefore, the area on the display panel corresponding to the connection portion 104 is reduced, which is conducive to ensuring that the area on the display panel corresponding to the connection portion 104 is evaporated with a film layer structure.

In an embodiment, with continued reference to FIG. 1, the shielding portion 103 is connected to the frame 101 through multiple connection portions 104, and the extension directions of at least two connection portions 104 are different. Exemplarily, in FIG. 1, the shielding portion 103 is connected to the frame 101 through two connection portions 104, and the extension directions of the two connection portions 104 are perpendicular to each other. In an embodiment, the shielding portion 103 may also be connected to the frame 101 through more connection portions 104, and the extension directions of multiple connection portions 104 are different.

In an embodiment, the shielding portion 103 and the frame 101 are fixedly connected by multiple connection portions 104 so that the shielding portion 103 can be better supported; at the same time, the extension directions of at least two connection portions 104 are different so that the connection portions 104 provide support for the shielding portion 103 along multiple directions, which is conducive to reducing the stress on each connection portion 104, to reducing the probability of deformation of the connection portion 104 causing the shielding portion 103 to tilt, and to improving the evaporation effect of the area arranged on the display panel corresponding to the shielding portion 103 and the connection portion 104.

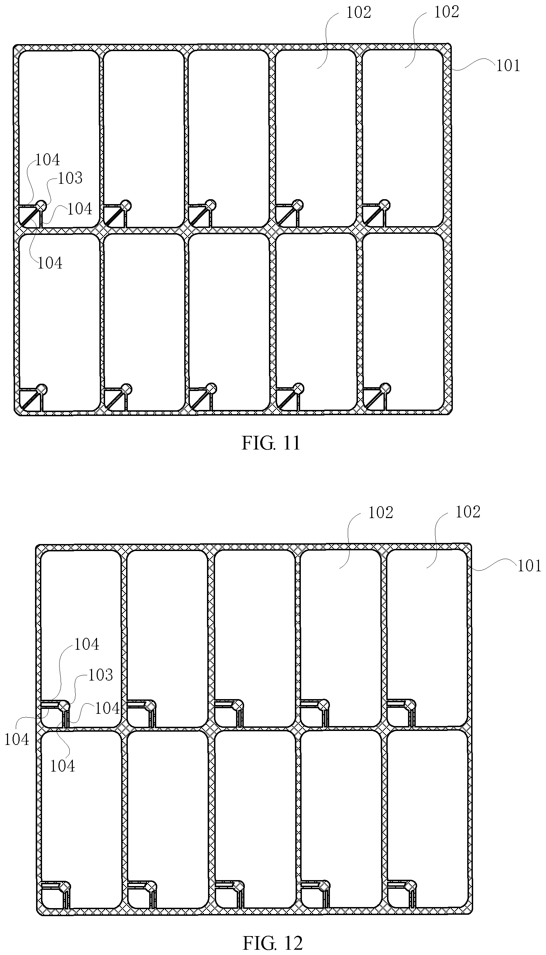

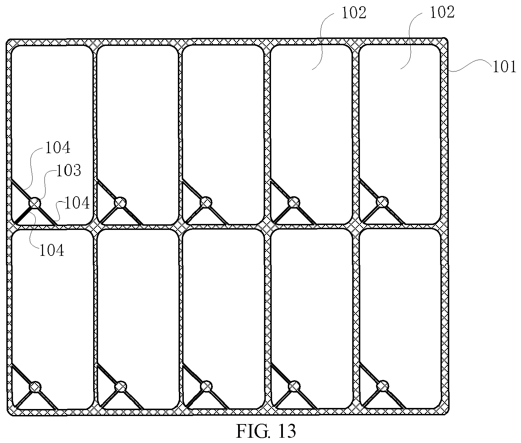

In an embodiment, the positional relationship between the connection portions and the shielding portion shown in FIG. 1 is only an example. Alternatively, as shown in FIG. 11, FIG. 11 is a structure diagram of another mask according to an embodiment of the present application. One shielding portion 103 may correspond to three connection portions 104, and the positional relationship of the three connection portions 104 is shown in FIG. 11. The extension directions of two connection portions 104 of the three connection portions 104 are perpendicular to each other, and the extension direction of another connection portion 104 is between the two connection portions that are perpendicular to each other. Alternatively, as shown in FIG. 12, FIG 12 is a structure diagram of another mask according to an embodiment of the present application. One shielding portion 103 may correspond to four connection portions 104, and the positional relationship of the four connection portions 104 is shown in FIG. 12. The extension directions of two connection portions 104 of the four connection portions 104 are parallel to a first direction, the extension directions of the other two connection portions 104 are parallel to a second direction, and the first direction is perpendicular to the second direction. Alternatively, as shown in FIG. 13, FIG. 13 is a structure diagram of another mask according to an embodiment of the present application. One shielding portion 103 may correspond to three connection portions 104, and the positional relationship of the three connection portions 104 is shown in FIG. 13. The extension directions of two connection portions 104 of the three connection portions 104 are the same and are located on the same straight line, and the extension direction of another connection portion 104 is perpendicular to the straight line.

In an embodiment, as shown in FIG. 9, along the direction perpendicular to the extension direction of the connection portion 104, the maximum width d of the connection portion 104 is greater than or equal to 150 µm and is less than or equal to 300 µm.

In an embodiment, if the maximum width of the connection portion 104 is too small, sufficient support cannot be provided for the shielding portion 103 and the shielding portion 104 sags greatly so that a large amount of evaporation material is evaporated on the area on the display panel corresponding to the shielding portion, and thus the yield of the display panel is seriously reduced. If the width of the connection portion 104 is too great, the area shielded by the connection portion 104 is also too great so that the evaporation material cannot be evaporated to all the areas on the display panel corresponding to the connection portion 104in an oblique manner, and thus the thickness of the film layer of multiple parts of the display panel is uneven, and the display effect is affected. The maximum width of the connection portion 104 is set to be greater than or equal to 150 µm and is less than or equal to 300 µm. In this manner, it is ensured that the connection portion 104 provides sufficient support for the shielding portion 103 and the area on the display panel corresponding to the shielding portion 103 is not evaporated with a film layer structure; and it is also ensured that the position on the display panel corresponding to the connection portion 104 is evaporated with a film layer structure and the display uniformity of the display panel is improved.

## Claims

1. A mask, comprising:
a frame;
an opening surrounded by the frame;
a shielding portion disposed in the opening; and
at least one connection portion each connecting the shielding portion and the frame,
wherein along a direction perpendicular to the mask, each of the at least one connection portion comprises a first part arranged close to a substrate to be evaporated and a second part arranged away from the substrate to be evaporated, a vertical projection of the second part covers a vertical projection of the first part, and an area of a cross-section of the first part parallel to the mask gradually decreases along a direction away from the second part.

2. The mask of claim 1, wherein along the direction perpendicular to the mask, an area of a cross-section of the second part parallel to the mask gradually decreases along a direction away from the first part.

3. The mask of claim 1, wherein a surface of the shielding portion close to the substrate to be evaporated is provided with at least one first groove; or
a surface of the shielding portion away from the substrate to be evaporated is provided with at least one first groove; or
a surface of the shielding portion close to the substrate to be evaporated is provided with at least one first groove, and a surface of the shielding portion away from the substrate to be evaporated is provided with at least one first groove.

4. The mask of claim 3, wherein the shielding portion comprises a middle area and an edge area surrounding the middle area, and the at least one first groove is located in the middle area.

5. The mask of claim 1, wherein a surface of each of the at least one connection portion close to the substrate to be evaporated is provided with at least one second groove; or
a surface of each of the at least one connection portion away from the substrate to be evaporated is provided with at least one second groove; or
a surface of each of the at least one connection portion close to the substrate to be evaporated is provided with at least one second groove, and a surface of each of the at least one connection portion away from the substrate to be evaporated is provided with at least one second groove.

6. The mask of claim 5, wherein the surface of each of the at least one connection portion close to the substrate to be evaporated is provided with the at least one second groove, and a plurality of protruding structures are disposed in each of the at least one second groove.

7. The mask of claim 6, wherein along the direction perpendicular to the mask, heights of the plurality of protruding structures are same; or
the plurality of protruding structures are evenly distributed; or
along the direction perpendicular to the mask, heights of the plurality of protruding structures are same; and the plurality of protruding structures are evenly distributed.

8. The mask of claim 1, wherein each of the at least one connection portion is arranged to be linear.

9. The mask of claim 8, wherein the shielding portion is connected to the frame through a plurality of connection portions, and extension directions of at least two of the plurality of connection portions are different.

10. The mask of claim 8, wherein along a direction perpendicular to an extension direction of each of the at least one connection portion, a maximum width of each of the at least one connection portion is greater than or equal to 150 µm and is less than or equal to 300 µm.

11. The mask of claim 6, wherein the plurality of protruding structures are arranged along a direction perpendicular to an extension direction of each of the at least one connection portion.

12. The mask of claim 6, wherein the plurality of protruding structures are arranged along an extension direction of each of the at least one connection portion.

13. The mask of claim 6, wherein part of the plurality of protruding structures are arranged in a direction perpendicular to an extension direction of each of the at least one connection portion, and remaining ones of the plurality of protruding structures are arranged along an extension direction of each of the at least one connection portion.

14. The mask of claim 6, wherein each of the plurality of protruding structures is a trapezoidal mesa-like structure.

15. The mask of claim 6, wherein a shape of a cross-section of each of the plurality of protruding structures along the direction perpendicular to an extension direction of each of the at least one connection portion is a regular trapezoid, a rectangle, or an inverted trapezoid.

16. The mask of claim 9, wherein the shielding portion is connected to the frame through three connection portions.

17. The mask of claim 16, wherein extension directions of two of the three connection portions are perpendicular to each other, and a remaining one of the three connection portions is located between the two of the three connection portions; or
extension directions of two of the three connection portions are same, the two of the three connection portions are located on a same straight line, and an extension direction of a remaining one of the three connection portions is perpendicular to the straight line.

18. The mask of claim 9, wherein the shielding portion is connected to the frame through four connection portions.

19. The mask of claim 13, wherein extending directions of two of the four connection portions are parallel to a first direction, and extending directions of remaining two of the four connecting portions are parallel to a second direction, and the first direction is perpendicular to the second direction.

20. The mask of claim 4, wherein a shape of the shielding portion is circular, and a shape of the edge area is annular.
